Europäisches Patentamt

European Patent Office

Office européen des brevets

(19)

(11) Publication number : **0 560 464 B1**

(12) # EUROPEAN PATENT SPECIFICATION

(45) Date of publication of patent specification :
27.12.95 Bulletin 95/52

(51) Int. Cl.⁶ : **H01L 39/12**

(21) Application number : 93201456.6

(22) Date of filing : 03.02.89

(54) **Superconductive oxide materials**

(30) Priority : **05.02.88 JP 26128/88**
**05.02.88 JP 26129/88**
**05.02.88 JP 26130/88**

(43) Date of publication of application :
**15.09.93 Bulletin 93/37**

(45) Publication of the grant of the patent :
**27.12.95 Bulletin 95/52**

(84) Designated Contracting States :
**DE FR GB**

(56) References cited :
**EP-A- 0 281 474**
**JAPANESE JOURNAL OF APPLIED PHYSICS**
**vol. 27, no. 2, February 1988, TOKYO, JP,**
**pages L209-L210, H. Maeda et al: "A new high**
**Tc oxide superconductor without a rare earth**
**element"**
**PHYSICA C, vol. 153-155, pt.1, June 1988,**
**pages 615-616, Amsterdam, NL; Seebacher B.**
**et al: "Superconductivity in the system Bi-**
**Sr-Ca-Cu-O" & CONFERENCE ON HIGH TC**
**SUPERCONDUCTORS AND MATERIALS AND**
**MECHANISMS OF SUPERCONDUCTIVITY, 28**
**February 1988, Interlaken, CH**

(60) Publication number of the earlier application in
accordance with Art. 76 EPC : **0 331 292**

(73) Proprietor : **MATSUSHITA ELECTRIC**
**INDUSTRIAL CO., LTD.**
**1006, Ohaza Kadoma**
**Kadoma-shi, Osaka-fu, 571 (JP)**

(72) Inventor : **Kugimiya, Kouichi**
**2-1-32, Chokojiminami,**
**Toyonaka-shi, Osaka, 560 (JP)**
Inventor : **Adachi,Seiji**
**Dai 2 Paradaisu Manshon 401**
**3-8-15,Kitasakae,Urayasu-shi,Chiba 279 (JP)**
Inventor : **Inoue, Osamu**
**2-124-9-901 Okubocho**
**Moriguchi, Osaka 570 (JP)**
Inventor : **Kawachima, Syunichiro**
**38-57 Indacho**
**Hirakata, Osaka 573 (JP)**

(74) Representative : **Wain, Christopher Paul et al**
**A.A. THORNTON & CO.**
**Northumberland House**
**303-306 High Holborn**
**London WC1V 7LE (GB)**

EP 0 560 464 B1

## Description

This invention relates to superconductive oxide materials.

Oxides of the YBaCuO type have recently been reported to be superconductive materials and various tests and studies on these materials have been made and are in progress. As a result, it has been shown that these materials are unstable and exhibit large differences between the starting temperature and the finishing temperature of the superconductive state. The price of these materials is also high because they contain a substantial proportion of a rare earth element; the cost of the latter is not only high, but fluctuates significantly.

Following on from these materials, superconductive oxides of the SrBiCuO type have been described, as for example in Z.Phys.B- Condensed Matter, vol.68, pages 421-423 (1987); C. Michael et al, "Superconductivity in the Bi-Sr-Cu-O System", and Chemical Engineering News, vol.266A, No. 5, 1st February 1988, page 5, R. Dagani, "New class of superconductors discovered".

It is a primary object of this invention to provide improved superconductive oxide materials and, specifically, improved oxide materials of the SrBiCuO type.

We have surprisingly found that by modifying the composition of such oxides so that they contain, instead of Sr alone, a mixture of at least one of Mg and Ca and at least one of Sr and Bi and by selecting compositions in which the atomic ratios fall within a defined area of a ternary composition diagram, materials having relatively high superconductive transition temperatures are obtained.

According to the present invention, there is provided a superconductive oxide material which consists, at least partially, of ABiCuO, where A is a mixture of at least one of Mg and Ca and at least one of Sr and Ba, the atomic ratio of A/Bi/Cu falling within a pentagonal area in a ternary composition diagram of A, Bi and Cu, defined by the points 3/2/3, 5/3/5, 6/3/5, 4/2/3 and 6/4/5, and the material having a superconductive transition temperature above 84°K.

It is a specific feature of the oxide materials of the invention that they contain alkaline earth metal atoms having an ion radius of less than 0.1 nm, Mg and/or Ca, and alkaline earth metal atoms having an ion radius of more than 0.1 nm, Sr and/or Ba. This feature provides adequate atom-to-atom distance in the crystal structure and it is believed that it is this characteristic which leads to the advantageous properties of the materials.

In arriving at the materials of the present invention, we studied YBaCuO-type oxides. We found that the preferred oxides of this type having an atomic ratio of Y/Ba/Cu of 1/2/3 (the so-called 123 ratio) have a transition temperature of about 90°K, but the temperature difference is nearly 10°K which is very substantial. If the composition of the oxide is slightly varied in order to alter the characteristics of the material, it is found that an undesirable impurity phase is formed. These disadvantages are not found in the oxides of the present invention as will be seen from the following description of experimental work we have carried out.

In our EP-A-0331292 from which the present application is divided, we have described and claimed a superconductive oxide material which consists, at least partially, of ABiCuO, where A i a mixture of at least one of Mg and Ca and at least one of Sr and Ba, the ABiCuO forming a crystal phase in which the atomic ratio of A/Bi/Cu is substantially 3/2/2, and the material having a superconductive transition temperature above 77°K. In the following description, we describe the preparation of some superconductive oxide materials of this sort, as well as of some materials in accordance with the present invention, and of some other materials (for comparison). In the following description, transition temperatures and temperature differences (the difference between the starting temperature and the finishing temperature of the superconductive state) are reported in °K and other temperatures, that is calcining and sintering temperatures, are reported in °C.

Mixtures of weighed amounts of one or both of magnesium and calcium oxides, one or both of strontium and barium oxides, bismuth oxide and copper oxide were formed so as to give atomic ratios A/Bi/Cu of 5/3/5 or 3/2/3 and also other A/Bi/Cu ratios. The oxides were thoroughly mixed and the mixture was calcined at 800 to 850°C, crushed, formed, and then sintered at 830 to 870°C.

The composition and characteristics of the materials obtained are shown in Table 1.

Table 1

| | | Composition | | | | | | Transition temperature | Temperature difference | Phase |
|---|---|---|---|---|---|---|---|---|---|---|
| | | Sr | Ca | Ba | Mg | Bi | Cu | | | |
| 1 | | 3.3 | 1.7 | 0 | 0 | 3 | 5 | 105 | 2 | Single |
| 2 | | 3.8 | 2.2 | 0 | 0 | 4 | 5 | 108 | 5 | Single |
| 3 | | 3.5 | 2.5 | 0 | 0 | 4 | 5 | 110 | 3 | Single |
| 4 | | 4.5 | 1.5 | 0 | 0 | 5 | 4 | 113 | 5 | Single |
| 5 | | 3.0 | 3.0 | 0 | 0 | 3 | 5 | 102 | 3 | Single |
| 6 | | 0.5 | 0.5 | 0 | 0 | 1 | 1 | 82 | 11 | Plural |
| 7 | | 1.0 | 1.0 | 0 | 0 | 1 | 2 | 101 | 11 | Plural |
| 8 | | 2.0 | 2.0 | 0 | 0 | 2 | 3 | 84 | 9 | Plural |
| 9 | | 2.0 | 2.0 | 1 | 1 | 4 | 5 | 106 | 4 | Single |
| 10 | | 2.0 | 2.0 | 1 | | 3 | 5 | 101 | 4 | Single |
| 11 | | 4.0 | 0.5 | 1 | 0.5 | 4 | 5 | 110 | 5 | Single |
| 12 | | 2.0 | 1.0 | 0.5 | 0.5 | 2 | 3 | 101 | 11 | Plural |
| 13 | | 2.0 | | 2.0 | | 2 | 3 | 23 | 9 | Plural |
| 14 | | 1.5 | 1.5 | | | 2 | 3 | 105 | 2 | Single |

As is clear from this Table, all the compositions in which the A/Bi/Cu ratio was 5/3/5 or 3/2/3 had temperature differences of 5°K or less and had transition temperatures over 100°K.

In further tests, the compositions of Table 1 were maintained for a month under conditions of elevated temperature and high humidity (60°C, 60%) and were compared with YBaCuO materials kept under the same conditions. At the end of this period, it was found that the YBaCuO materials had largely disintegrated and had whitened all over, whilst the compositions of Table 1 remained very stable and exhibited only slight superficial whitening.

The properties of compositions 2, 3, 4, 5 and 14 of Table 1 were particularly good; satisfactory properties were also noted with compositions 10, 11 and 12 in which a part of the primary alkaline earth element, Sr, is replaced by Ba (composition 10) and a part of the elements Sr and Ca is replaced by Ba and Mg respectively (compositions 11 and 12).

X-ray analysis of the compositions having A/Bi/Cu ratios of 3/2/3 and 5/3/5 showed that they contained a substantial proportion of a crystal phase. Whilst this crystalline phase is still being investigated, preliminary indications are that it is composed of a pseudotetragonal superlattice having a unit cell of 0.54 nm. Taking this observation together with the results of transmission electron microscope observations, it is considered that the crystal can be nominally expressed as being orthorhombic with the lattice constants: a = 0.54 nm, b = 0.54 x 5 = 2.7 nm and c = 1.53 x 2 = 3.06 nm. This crystalline phase is very easy to cleave on the C-plane.

A further series of compositions of the ABiCuO type were made in the same manner as described above.

The thoroughly mixed oxides were calcined at 800 to 850°C, the mixture was then crushed, formed and sintered at 850°C.

The compositions and characteristics of the materials obtained are shown in Table 2.

## Table 2

| | Composition | | | | | | Transition temperature | Temperature difference | Phase | Humidity resistance |
|---|---|---|---|---|---|---|---|---|---|---|
| | Sr | Ca | Ba | Mg | Bi | Cu | | | | |
| 1 | 1.5 | 1.5 | 0 | 0 | 2 | 2 | 83 | 2 | Single | Good |
| 2 | 3.0 | 3.0 | 0 | 0 | 4 | 5 | 80 | 4 | Single | Good |
| 3 | 2.5 | 2.5 | 0 | 0 | 5 | 4 | 85 | 4 | Single | Good |
| 4 | 4.5 | 4.5 | 0 | 0 | 6 | 5 | 82 | 5 | Single | Good |
| 5 | 3.0 | 3.0 | 0 | 0 | 3 | 4 | 84 | 4 | Single | Good |
| 6 | 0.5 | 0.5 | 0 | 0 | 1 | 1 | 82 | 11 | Plural | Good |
| 7 | 1.0 | 1.0 | 0 | 0 | 1 | 1 | 79 | 17 | Plural | Fair |
| 8 | 2.0 | 2.0 | 0 | 0 | 2 | 3 | 84 | 9 | Plural | Fair |
| 9 | 1.0 | 1.0 | 0.5 | 0.5 | 2 | 2 | 81 | 5 | Single | Good |
| 10 | 2.0 | 2.0 | 1 | 1 | 4 | 5 | 80 | 4 | Single | Good |
| 11 | 4.0 | 0.5 | 4 | 0.5 | 6 | 5 | 79 | 10 | Single | Good |
| 12 | 2.0 | 1.0 | 0.5 | 0.5 | 2 | 3 | 77 | 11 | Plural | Fair |
| 13 | 2.0 | | 2 | | 2 | 3 | 23 | 9 | Plural | Fair |

It will be seen from the Table that compositions 1-5, 9 and 10 had a temperature difference of 5°K or less and a transition temperature in the range of 80° to 85°K. All of these compositions also had good humidity resistance when tested by the same procedure as described above, one month at 60°C and 60% relative humidity.

X-ray analysis of composition 1 having an ABiCu ratio of 3/2/2 indicated that it was formed of a pseudotetragonal superlattice having a unit cell of 0.54 nm. This observation taken together with transmission electron microscope observations, indicate that the crystalline phase can be nominally expressed as being orthorhombic with the lattice constants: $a = 0.54 \times \sqrt{2} \times 2 = 1.53$ nm and $b = c = 0.54 \times \sqrt{2} \times 3 = 2.29$ nm or $a = 0.54$ nm, $b = 0.54 \times 5 = 2.7$ nm, $c = 1.53 \times 2 = 3.06$ nm.

A third series of compositions of the ABiCuO type were made. Weighed amounts of one or both of magnesium and calcium oxides, one or both of strontium and barium oxides, bismuth oxide and copper oxide were combined to form mixtures in which the A/Bi/Cu ratio was approximately 3/2/2 - these were mixtures A. Mixtures of weighed amounts of the alkaline earth metal oxides and copper oxide were also formed in which the A/Bi/Cu ratio was 1/0/2 - these were mixtures B. Weighed amounts of mixtures A and B were combined and the resulting mixtures were thoroughly mixed. The compositions were calcined at 800°C to 850°C, crushed, formed and then sintered at 850°C for 6 hours, they were kept at 820°C and then gradually cooled at a rate of 50°C/hour.

The compositions and characteristics of the materials obtained are shown in Table 3.

| | Composition | | | | | | Transition temperature | Temperature difference |
|---|---|---|---|---|---|---|---|---|
| | Sr | Ca | Ba | Mg | Bi | Cu | | |
| 1 | 2.5 | 2.5 | 0 | 0 | 3 | 4 | 103 | 4 |
| 2 | 1.5 | 2.0 | 0 | 0 | 2 | 3 | 106 | 5 |
| 3 | 1.0 | 1.0 | 0 | 0 | 1 | 2 | 112 | 3 |
| 4 | 1.5 | 1.0 | 0 | 0 | 1 | 3 | 107 | 5 |
| 5 | 1.5 | 1.5 | 0 | 0 | 1 | 4 | 82 | 6 |
| 6 | 1.5 | 1.5 | 0.5 | 0 | 2 | 3 | 101 | 5 |
| 7 | 0.5 | 1.0 | 0 | 0.5 | 1 | 2 | 109 | 4 |
| 8 | 0.2 | 1.0 | 0.3 | 0.5 | 1 | 2 | 100 | 3 |

It will be seen from the Table that all the compositions had a temperature difference of 6°K or less and, apart from composition 5, they all had transition temperatures above 100°K, the highest transition temperature, 112°K, being exhibited by composition 3 in which the A/Bi/Cu ratio was 2/1/2.

All the compositions had good humidity resistance when tested by the same procedure as described above, one month at 60°C and 60% relative humidity.

X-ray analysis of composition 3 showed that it contained two crystal phases, the first consisting of material having an A/Bi/Cu ratio of 3/2/2 and the second of material having an A/Bi/Cu ratio of 1/0/2. These phases were present in equal amounts so that the overall composition had a ratio of 4/3/4, that is 2/1/2. X-ray analysis indicated that the first (3/2/2) phase consisted of a pseudotetragonal superlattice having a unit cell of 0.54 nm. Such analysis, together with transmission electron microscope observations, indicate that this crystal phase can be nominally expressed as being orthorhombic with the lattice constants: $a = 1.53$ nm, $b = c = 2.29$ nm or $a = 0.54$ nm, $b = 2.7$ nm, $c = 3.06$ nm.

The second phase consisted of $Ca, Cu_2O_3$. The two crystalline phases were mutually overlaid, that is they formed alternate layers in a sandwich arrangement, and they formed a thin precipitation layer within the sintered particles of the composition. It is postulated that the specific characteristics of this material are due to phenomena occurring at the interface of the two crystal phases.

Multiple alternate layers of these phases were formed artificially by magnetron sputtering of mixtures A and B referred to above used to form composition 3 of Table 3, that is mixtures having the ratios 3/2/2 and 1/0/2 respectively. The magnetron sputtering was carried out using separate targets of mixture A and of mixture B and thin films of each were alternately laid down on a substrate in an atmosphere of argon gas containing 4% of oxygen while maintaining the substrate temperature at 550°C.

Several specimens were prepared in which the thickness of the individual layers was varied from 20 to 100 nm. Most of the specimens has a transition temperature of 100°K or higher, though a smaller number had a transition temperature of about 80°K due, it is believed, to the presence of an impurity phase.

Since the deposition temperature was kept low, it was considered that there was little interlaminar diffusion, this was confirmed by electron microscope examination of sections of the specimens.

It was found that optimum performance was obtained when the thickness ratio was substantially 1/1.

It will be seen from the foregoing that the superconductive materials according to the invention have high transition temperatures (generally above 100°K), small temperature differences (generally about 5°K or less), good humidity resistance, a broad solid solution range, and are superior in stability and reproducibility. They may be widely used in superconductive appliances.

**Claims**

1. A superconductive oxide material which consists, at least partially, of ABiCuO, where A is a mixture of at least one of Mg and Ca and at least one of Sr and Ba, the atomic ratio of A/Bi/Cu falling within a pentagonal area in a ternary composition diagram of A, Bi and Cu, defined by the points 3/2/3, 5/3/5, 6/3/5, 4/2/3 and 6/4/5 and the material having a superconductive transition temperature above 84°K.

**Patentansprüche**

1. Ein supraleitender Oxidstoff, bestehend aus wenigstens ABiCuO, wobei A eine Mischung aus wenigstens einem Mg und Ca und wenigstens einem Sr und Ba besteht, während das atomare Verhältnis von A/Bi/Cu in einen fünfseitigen Bereich eines ternären Zusammensetzungsbildes von A, Bi und Cu fällt, das durch die Punkte 3/2/3, 5/3/5, 6/3/5, 4/2/3 und 6/4/5 bestimmt wird und das Material eine supraleitende Sprungtemperatur über 84°K aufweist.

**Revendications**

1. Un matériau supraconducteur qui consiste, au moins en partie, en ABiCuO, dans lequel A est un mélange d'au moins un parmi Mg et Ca et au moins un parmi Sr et Ba, le rapport atomique de A/Bi/Cu tombant dans une zone pentagonale dans un diagramme de la composition tertiaire de A, Bi et Cu, définie par les points 3/2/3, 5/3/5, 6/3/5, 4/2/3 et 6/4/5 et le matériau ayant une température de transition supraconductrice au dessus de 84°K.